# FASCICULE DE BREVET EUROPEEN

(11) **EP 2 461 484 B1**
(45) Date de publication et mention de la délivrance du brevet: **18.10.2017**
(21) Numéro de dépôt: 11306114.7
(22) Date de dépôt: 07.09.2011
(51) Int. Cl.: H03K 19/177, G06F 11/14, G06F 15/78

(54) **Dispositif amélioré pour la configuration d'un composant programmable, système intégrant ce dispositif, et procédé associé**
Verbesserte Vorrichtung für die Konfiguration eines programmierbaren Bauteils, diese Vorrichtung umfassendes System und entsprechendes Verfahren
Improved device for configuring a programmable component, system including said device and associated method

(30) Priorité: 08.09.2010 FR 1003578
(43) Date de publication de la demande: 06.06.2012
(73) Titulaire: Thales, 92200 Neuilly Sur Seine (FR)
(72) Inventeur: Murzeau, Jean, 49309 Cholet Cedex (FR); Galland, Jacques, 49309 Cholet Cedex (FR); Geairon, Sébastien, 49309 Cholet Cedex (FR)
(74) Mandataire: Lavoix

(56) Documents cités:
- US-A1- 2009 085 603
- US-B1- 7 631 223

## Description

L'invention a pour domaine celui des composants programmables. Plus particulièrement, l'invention a pour domaine celui des composants programmables capables de gérer la mise à jour de leur propre configuration.

Lors de la mise sous tension d'un système comportant un composant programmable devant être configuré, ce dernier initie une phase de configuration au cours de laquelle il lit un fichier de configuration (« bitstream ») contenu dans une mémoire morte à laquelle est directement connecté le composant programmable.

A l'issue de la phase de configuration, si le fichier de configuration ne comporte pas d'erreur, le composant programmable est configuré conformément au fichier de configuration.

Dans certaines configurations, un microprocesseur est ainsi « embarqué » dans le composant programmable. Ce microprocesseur est alors apte à exécuter les instructions d'un code applicatif stocké dans une autre mémoire morte, dite mémoire d'application, qui est également connectée directement au composant programmable. Le code applicatif est dédié au microprocesseur qui a été configuré et est donc associé à un fichier de configuration.

Avantageusement, le code applicatif permet, grâce au microprocesseur, de télécharger depuis l'extérieur du système et d'écrire dans les mémoires correspondantes, un nouveau fichier de configuration et le code applicatif associé. Ce nouveau fichier de configuration correspond par exemple à une version du microprocesseur intégrant des évolutions fonctionnelles, des corrections de « bogues », etc.

En revanche, si le fichier de configuration est corrompu, la phase de configuration du composant programmable échoue et le composant programmable se trouve dans un état qui ne permet pas l'exécution du code applicatif.

Dans cette situation, le système n'est pas fonctionnel. En particulier, il est incapable de télécharger un nouveau fichier de configuration qui permettrait une reconfiguration correcte du composant programmable. Il est ainsi nécessaire de rapporter le système chez son fabriquant pour que celui-ci force la reconfiguration du composant programmable à partir d'un fichier de configuration stocké dans une mémoire externe au système, mémoire à laquelle le composant programmable accède au moyen d'un connecteur amovible du type « JTAG ». Le document US 7 631 223 A1 décrit un dispositif programmable comportant
- un composant programmable capable de gérer sa propre configuration, à partir de la donnée d'un fichier de configuration, ayant une entrée apte à recevoir un signal de reconfiguration;
- un circuit de fiabilisation automatique de la configuration du composant programmable, comportant un moyen de sélection à au moins deux états, dans un premier état, le moyen de sélection est propre à connecter le composant programmable à un premier espace mémoire de configuration comportant un premier fichier de configuration, au moins quand le composant programmable cherche à accéder en lecture à un fichier de configuration et, dans un second état, le moyen de sélection est propre à connecter le composant programmable à un second espace mémoire de configuration comportant un second fichier de configuration, au moins quand le composant programmable cherche à accéder en lecture à un fichier de configuration. Le composant programmable est capable de vérifier la cohérence d'un premier fichier de configuration du dispositif programmable, lorsque ce dernier accède à une première mémoire externe où est stocké ledit premier fichier de configuration. Si une erreur est détectée par le contrôleur lors du chargement dans la mémoire interne du dispositif programmable, le chargement du premier fichier est interrompu et le dispositif programmable accède à une seconde mémoire externe où est stocké un second fichier de configuration.

L'invention a donc pour but de répondre aux problèmes précités. En particulier, l'invention a pour but de fiabiliser le démarrage d'un composant programmable.

A cette fin, l'invention a pour objet un dispositif comportant :
- un composant programmable capable de gérer sa propre configuration, à partir de la donnée d'un fichier de configuration, ayant une sortie apte à émettre un signal d'inhibition lors d'une configuration réussie du composant programmable et une entrée (CONFIG) apte à recevoir un signal de reconfiguration ;
- un circuit de fiabilisation automatique de la configuration du composant programmable, comportant :
- un moyen de sélection à au moins deux états, dans un premier état, le moyen de sélection est propre à connecter le composant programmable à un premier espace mémoire de configuration comportant un premier fichier de configuration, au moins quand le composant programmable cherche à accéder en lecture à un fichier de configuration et, dans un second état, le moyen de sélection est propre à connecter le composant programmable à un second espace mémoire de configuration comportant un second fichier de configuration, au moins quand le composant programmable cherche à accéder en lecture à un fichier de configuration ; et,
- un moyen de surveillance ayant une entrée (WDI1) apte à recevoir le signal d'inhibition émis par le composant programmable et une sortie (WD0) apte à émettre, lorsque aucun signal d'inhibition n'a été reçu pendant une durée prédéterminée, un signal de reconfiguration à destination du composant programmable pour en commander la reconfiguration et du moyen de sélection pour en modifier l'état.

Suivant des modes particuliers de réalisation, le dispositif comporte une ou plusieurs des caractéristiques suivantes, prise(s) isolément ou suivant toutes les combinaisons techniquement possibles :
- le composant programmable, une fois configuré en tant que microprocesseur, est propre à exécuter un code applicatif associé au fichier de configuration utilisé, et le moyen de sélection est propre à :
   - dans ledit premier état, connecter le composant programmable à un premier espace mémoire d'application (32) comportant un premier code d'application (33), au moins quand le composant programmable cherche à accéder en lecture à un code d'application ; et,
   - dans ledit second état, connecter le composant programmable à un second espace mémoire d'application (34) comportant un second code d'application (35), au moins quand le composant programmable cherche à accéder en lecture à un code d'application.
- le moyen de sélection comporte :
   - une bascule à au moins deux états comportant une entrée (CLK) de commande d'une modification de l'état de la bascule et une sortie (Q) d'indication de l'état courrant de la bascule, ladite entrée étant connectée à ladite sortie (WD0) du moyen de surveillance apte à émettre un signal de reconfiguration ; et,
   - une pluralité de composants logiques propre à connecter le composant programmable au premier espace mémoire de configuration ou au second espace mémoire de configuration, en fonction de l'état courrant de la bascule.
- la pluralité de composants logiques est propre à connecter le composant programmable au premier espace mémoire d'application ou au second espace mémoire d'application, en fonction de l'état courant de la bascule.
- le composant programmable comporte une patte de sortie (CS0) sur laquelle il est propre à émettre un signal d'accès indiquant qu'il cherche à accéder à un fichier de configuration, et la pluralité de composants logiques est propre à connecter le composant programmable au premier espace mémoire de configuration ou au second espace mémoire de configuration, en fonction de l'état courrant dudit signal d'accès.
- le composant programmable comporte une patte de sortie (ADR0[24]) sur laquelle il est propre à émettre un signal d'accès indiquant qu'il cherche à accéder à un code applicatif, et la pluralité de composants logiques est propre à connecter le composant programmable au premier espace mémoire d'application ou au second espace mémoire d'application, en fonction de l'état courrant dudit signal d'accès.
- le premier espace mémoire de configuration est une mémoire non reconfigurable et comporte un fichier de configuration usine, en ce que ledit second espace mémoire de configuration est une mémoire reconfigurable et comporte un fichier de configuration de mise à jour, et le composant programmable étant configuré à partir du fichier de configuration usine ou du fichier de configuration de mise à jour, ledit moyen de sélection est propre à connecter le composant programmable au second espace mémoire de configuration, au moins quand le composant programmable cherche à accéder en écriture à une mémoire de configuration, pour y écrire un nouveau fichier de configuration de mise à jour.
- le composant programmable comporte une sortie (WR) sur laquelle il est propre à émettre un signal de sélection en écriture d'un espace mémoire de configuration dans lequel écrire un nouveau fichier de configuration, et la pluralité de composants logiques est propre à connecter le composant programmable au premier espace mémoire de configuration ou au second espace mémoire de configuration, en fonction dudit signal de sélection en écriture.
- le composant programmable comporte le circuit de fiabilisation de la configuration.
- le composant programmable est du type FPGA.

L'invention a également pour objet un système programmable, caractérisé en ce qu'il comporte un dispositif conforme au dispositif présenté précédent, ainsi que des premier et second espace de mémoire de configuration comportant respectivement des premier et second fichiers de configuration, et des premier et second espaces mémoire d'application comportant respectivement des premier et second codes applicatifs, le premier code étant exécutable par le composant programmable dudit dispositif configuré à partir dudit premier fichier de configuration et le second code étant exécutable par le composant programmable dudit dispositif configuré à partir dudit second fichier de configuration, le circuit de fiabilisation de la configuration du composant programmable servant d'interface de connexion entre le composant programmable et lesdits espaces mémoire.

De préférence, le système est fermé.

L'invention a également pour objet un procédé tel que revendiqué dans la revendication 13. Des modes de fonctionnement particuliers de l'invention sont spécifiés dans les revendications dépendantes attenantes. L'invention et ses avantages seront mieux compris à la lecture de la description qui va suivre, donnée uniquement à titre d'exemple, et faite en se référant aux dessins annéxés sur lesquels :
- la Figure 1 est une représentation schématique d'un mode de réalisation du système comportant un composant programmable et un circuit de fiabilisation de sa configuration ;
- la Figure 2 est un organigramme représentant les étapes de la configuration du composant programmable de la Figure 1 ;
- la Figure 3 est un organigramme représentant les étapes de l'écriture par le composant programmable de la Figure 1 d'un nouveau fichier de configuration à la place d'un fichier de configuration corrompu ; et,
- la Figure 4 est un chronogramme représentant les états de différents composants du système de la Figure 1.

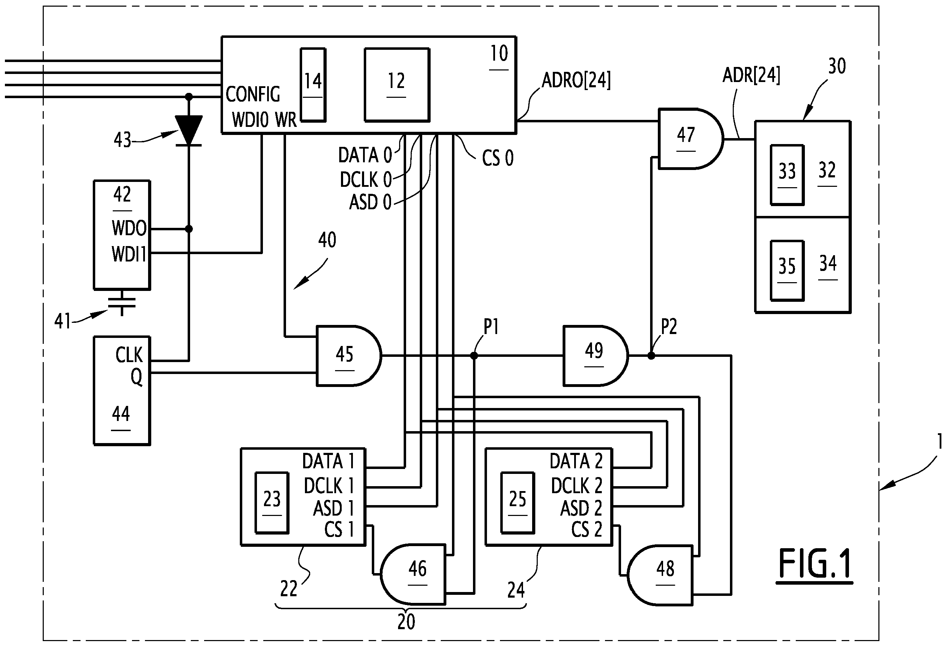

Le système 1 représenté sur la Figure 1 comporte :
- un composant programmable 10 ;
- une mémoire de configuration 20 ;
- une mémoire d'application 30 ; et,
- un circuit 40 de fiabilisation de la configuration du composant programmable regroupant l'ensemble des autres composants représentés sur la figure 1.

Le composant programmable 10 est du type FPGA («Field Programmable Gate Array»). Il comporte un coeur programmable 12 comprenant une pluralité de pattes d'entrée/sortie et d'éléments logiques. Le coeur 12 comprend également une matrice de routage programmable pour connecter les éléments logiques entre eux et/ou avec les pattes d'entrée/sortie.

Le composant programmable 10 comporte également un bloc logique de configuration 14 apte à réaliser la configuration du coeur 12 à partir d'un fichier de configuration que le bloc logique 14 lit dans une mémoire morte de configuration connectée au composant programmable.

Une fois le composant programmable correctement configuré, le coeur 12 est apte à lire un code d'application à exécuter dans une mémoire morte d'application connectée au composant programmable.

La mémoire de configuration 20 comporte une première mémoire morte 22 du type mémoire Flash et une seconde mémoire morte 24 du type mémoire Flash. La première mémoire stocke un premier fichier de configuration 23. La seconde mémoire stocke un second fichier de configuration 25.

La mémoire d'application 30 comporte une mémoire morte du type mémoire Flash comprenant une première zone mémoire 32 et une seconde zone mémoire 34. La première zone stocke un premier code applicatif 33. La seconde zone stocke un second code applicatif 35.

Le circuit de fiabilisation 40 comporte un moyen de surveillance et un moyen de sélection à au moins deux états. Le moyen de surveillance est un circuit de surveillance (« WatchDog Circuit » en anglais) 42, tandis que le moyen de sélection comporte les éléments suivants :
- Une bascule 44 à deux états ;
- Quatre éléments logiques « OU » 45 à 48 aptes à générer en sortie un signal binaire dont la valeur correspond à un « OU » entre les valeurs des deux signaux binaires qui lui sont appliqués en entrée ; et,
- Un élément logique inverseur 49 apte à générer en sortie un signal binaire dont la valeur est opposée à la valeur du signal binaire qui lui est appliqué en entrée.

Le composant programmable 10 comporte les pattes de connexion suivantes :
- CONFIG : patte d'entrée sur laquelle est reçu un signal de reconfiguration du composant programmable ;
- WDI0, pour « WatchDog Input » : patte de sortie sur laquelle est émis un signal d'inhibition du circuit de surveillance ;
- WR, pour « WRite select» : patte de sortie sur laquelle est émis un signal de sélection en écriture permettant de sélectionner l'espace mémoire dans lequel écrire un nouveau fichier de configuration : si le niveau de ce signal est bas, l'écriture s'effectue dans l'espace mémoire dont le fichier de configuration a été utilisé pour réaliser la configuration courante du composant programmable ; si le niveau de ce signal est haut, l'écriture s'effectue dans l'espace mémoire opposé à celui contenant le fichier de configuration qui a été utilisé pour réaliser la configuration courante du composant programmable ;

- DATA0, DCLK0, ASD0 : trois pattes de lecture/écriture dans la mémoire de configuration connectée au composant programmable ;
- CS0 : patte de sortie sur laquelle est émis un signal d'accès à la mémoire de configuration connectée au composant programmable ;
- ADR0[24] : patte de sortie sur laquelle est émis un signal indiquant une phase d'écriture d'un nouveau code applicatif dans la mémoire d'application connectée au composant programmable.

La première mémoire de configuration 22 comporte les pattes de connexion suivantes :
- DATA1, DCLK1, ASD1 : trois pattes d'accès en lecture/écriture à la mémoire ;
- CS1 : patte d'entrée de réception d'un signal d'accès indiquant la sélection de la mémoire.

La seconde mémoire de configuration 24 comporte les pattes de connexion suivantes :
- DATA2, DCLK2, ASD2 : trois pattes d'accès en lecture/écriture à la mémoire ;
- CS2 : patte d'entrée de réception d'un signal d'accès indiquant la sélection de la mémoire.

La mémoire d'application 30 comporte une patte d'adressage correspondant au bit de poids le plus fort (ici le bit 24). Si l'état du signal appliqué sur cette patte est bas 0, l'adresse de la mémoire 30 qui sera accédée appartiendra à la première zone 32. Si l'état du signal appliqué sur cette patte est haut 1, l'adresse de la mémoire 30 qui sera accédée appartiendra à la seconde zone 34. La mémoire d'application comporte une pluralité d'autres pattes connectées à autant de pattes du composant programmable 10 pour sélectionner une adresse en mémoire et des pattes permettant la lecture et l'écriture du composant programmable à l'adresse sélectionnée. Ces différentes pattes n'ont pas été représentées sur la Figure 1 pour des raisons de clarté.

Le circuit de surveillance 42 comporte une patte d'entrée WDI1 connectée à la patte de sortie WDI0 du composant programmable et une patte de sortie WDO (« WatchDog Input ») connectée, à travers une diode 43, à la patte d'entrée CONFIG du composant programmable. Le circuit de surveillance 42 est propre à émettre un signal de reconfiguration sur sa sortie WDO1, lorsque aucun signal d'inhibition n'a été appliqué sur son entrée WDI1 depuis une durée D prédéterminée. La durée D est ajustable en choisissant les valeurs du condensateur 41.

La bascule 44 est bistable. Elle peut être dans un état bas 0 ou dans un état haut 1. Cet état est maintenu même lorsque le système est hors tension.

Un signal d'état de la bascule est émis sur la patte de sortie Q de celle-ci.

La bascule 44 comporte également une patte d'entrée CLK de commande d'un changement d'état de la bascule. Cette entrée est connectée à la sortie WDO du circuit de surveillance 42. Ainsi, à chaque réception d'un signal de reconfiguration en provenance du circuit de surveillance 42, la bascule 44 change d'état et passe du niveau haut 1 vers le niveau bas 0 ou du niveau bas 0 au niveau haut 1.

La patte de sortie Q de la bascule 44 et la patte WR du composant programmable 10 sont connectées en entrée du premier élément logique « OU » 45, dont la sortie est connectée au noeud P1.

L'entrée de l'élément logique inverseur 49 est connectée au noeud P1, tandis que sa sortie est connectée au noeud P2. Ainsi, si le signal en P1 est haut 1, le signal en P2 sera bas 0 et si le signal en P1 est bas 0, le signal en P2 sera haut 1.

Les trois pattes DATA1, DCLK1 et ASD1 de la première mémoire de configuration 22 sont connectées aux pattes correspondantes DATA0, DCLK0, ASD0 du composant programmable 10.

La patte CS1 de la première mémoire de configuration 22 est reliée à la sortie du second élément logique « OU » 46, dont les entrées sont respectivement connectées au noeud P1 et à la patte CS0 du composant programmable 10.

Les trois pattes DATA2, DCLK2 et ASD2 de la seconde mémoire de configuration 24 sont également connectées aux pattes correspondantes DATA0, DCLK0, ASD0 du composant programmable 10, en dérivation des connexions correspondantes entre la première mémoire de configuration 22 et le composant programmable 10.

La patte CS2 de la seconde mémoire de configuration 24 est reliée à la sortie du troisième élément logique « OU » 48, dont les entrées sont respectivement connectées au noeud P2 et à la patte CS0 du composant programmable, en dérivation de la connexion correspondante entre la première mémoire de configuration 24 et le composant programmable 10.

Enfin, les entrées du quatrième élément logique « OU » 47 sont respectivement connectées à la patte de sortie ADR0[24] du composant programmable 10 et au noeud P2, tandis que la sortie du quatrième élément logique « OU » 47 est reliée à la patte ADR[24] de la mémoire d'application 30.

Les éléments logiques effectuent une opération logique « OU Exclusif » dont le tableau de vérité est le suivant :

| **ENTREE 1** | **ENTREE 2** | **SORTIE** |
|---|---|---|
| 0 | 0 | 0 |
| 0 | 1 | 1 |
| 1 | 0 | 1 |
| 1 | 1 | 0 |

Sur cette base, le tableau de vérité suivant indique les différents états possibles du système, en indiquant le niveau du signal sur les pattes ou noeuds indiqués par leurs références (les références qui sont soulignées correspondent à des variables décisionnelles, tandis que les autres références correspondent à des variables calculées)

| **Q** | **WR** | **P1** | **P2** | **CS0** | **CS1** | **CS2** | **ADR0[24]** | **ADR[24]** |
|---|---|---|---|---|---|---|---|---|
| 0 | 0 | 0 | 1 | 0 | 0 | 1 | 0 | 1 |
| | | | | 1 | 1 | 0 | 1 | 0 |
| 0 | 1 | 1 | 0 | 0 | 1 | 0 | 0 | 0 |
| | | | | 1 | 0 | 1 | 1 | 1 |
| 1 | 0 | 1 | 0 | 0 | 1 | 0 | 0 | 0 |
| | | | | 1 | 0 | 1 | 1 | 1 |
| 1 | 1 | 0 | 1 | 0 | 0 | 1 | 0 | 1 |
| | | | | 1 | 1 | 0 | 1 | 0 |

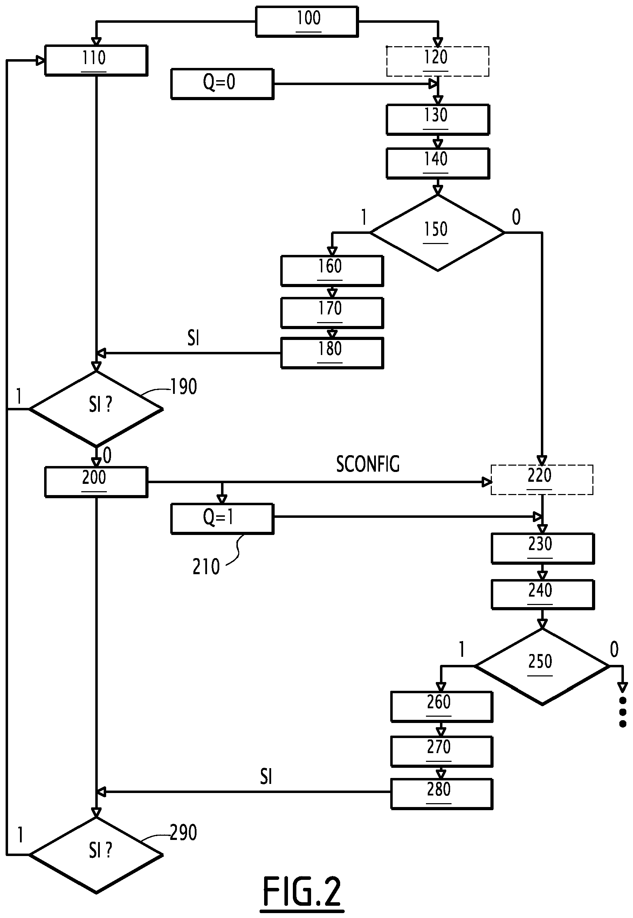

Le procédé mis en oeuvre par le système précédemment décrit va maintenant être présenté par référence à la Figure 2.

A l'étape 100 le système est mis sous tension. Cela a pour effet d'initialiser l'horloge du circuit de surveillance 42 (étape 110). A cet instant la bascule 44 est, par exemple, dans l'état bas 0.

Cela a également pour effet que le bloc logique 14 du composant programmable 10 initie une phase de configuration 120. Celle-ci débute par une étape au cours de laquelle le composant programmable cherche à accéder à un fichier de configuration. Le signal CS0 passe alors dans l'état haut 1.

La bascule 44 étant dans l'état bas 0 et le signal WR étant, par exemple, dans l'état bas 0, le signal au noeud P1 est dans l'état bas 0, tandis que celui au noeud P2 est dans l'état haut.

Il s'en suit que la sortie de l'élément logique 46 est dans l'état haut 1 et que la sortie de l'élément logique 48 est dans l'état bas 0.

En conséquence, le circuit de fiabilisation de la configuration permet au composant programmable 10 d'accéder (étape 130) à la première mémoire de configuration 22.

Le composant programmable 10 lit alors le premier fichier de configuration 23.

Une fois cette lecture terminée, le signal CS0 repasse dans l'état bas 0.

A l'étape 140, le bloc logique 14 configure le coeur 12 du composant programmable conformément au premier fichier de configuration.

Si la configuration du composant programmable s'achève avec succès (étape 150 = 1), le composant programmable 10 cherche ensuite à accéder à un code applicatif à exécuter. Pour cela il émet un signal ADR0[24] dans l'état haut 1.

Compte tenu du fait que l'autre entrée de l'élément logique 47 est dans l'état haut 1, la sortie de l'élément logique 47 est dans l'état bas 0. En conséquence, le composant programmable 10 accède à une zone de la mémoire d'application regroupant les adresses dont le bit de poids fort vaut 0. Ainsi, le composant programmable accède à la première zone 32 de la mémoire d'application. A l'étape 160, le composant programmable lit le premier code applicatif 33. Il s'agit effectivement du code qui est exécutable par le premier microprocesseur résultant de la configuration du composant programmable selon le premier fichier 23.

A l'étape 170, le composant programmable exécute ce premier code applicatif qui comporte, entre autre, des instructions relatives à l'émission d'un signal d'inhibition du circuit de fiabilisation 40.

En conséquence, à l'étape 180, le composant programmable 10 émet un signal d'inhibition SI prenant la valeur haute 1.

Le signal d'inhibition SI étant reçu par le circuit de surveillance 42 avant la fin de la durée D (étape 190 = 1), le circuit de surveillance 42 réinitialise son horloge (retour à l'étape 110).

Si, en revanche la phase de configuration du composant programmable à partir du premier fichier n'aboutit pas (étape 150 = 0), par exemple parce que ce premier fichier de configuration est corrompu, le circuit de surveillance 42 ne reçoit aucun signal d'inhibition SI au cours de la durée D (étape 190 = 0).

En conséquence, à l'étape 200, le circuit de surveillance 42 émet un signal de reconfiguration SCONFIG.

Le signal de reconfiguration est appliqué sur l'entrée CONFIG du composant programmable 10 de manière à ce que le bloc logique 14 du composant programmable initie une nouvelle phase de configuration (étape 220).

Simultanément, le signal de reconfiguration est appliqué en entrée de la bascule 44 pour en modifier l'état. L'état courrant de la bascule passe de la valeur 0 à la valeur 1 (étape 210).

Le signal Q étant dans l'état haut 1 et le signal WR étant dans l'état bas 0, le signal au noeud P1 est dans l'état haut 1, tandis que celui au noeud P2 est dans l'état bas 0.

Ainsi, lorsque la phase de configuration conduit à l'émission sur la patte CS0 d'un signal d'accès à la mémoire de configuration, le signal en sortie de l'élément logique 46 est dans l'état bas 0, alors que le signal en sortie du l'élément logique 48 est dans l'état haut 1. De ce fait, le composant programmable est maintenant connecté à la seconde mémoire de configuration 24 et y accède (étape 230).

Le composant programmable 10 lit alors le second fichier de configuration 25.

Une fois cette lecture terminée, le signal CS0 repasse dans son état bas 0.

A l'étape 240, le bloc logique 14 configure le coeur 12 du composant programmable conformément à ce second fichier de configuration dans le but de le configurer en tant que second microprocesseur.

Si la configuration du composant programmable s'achève avec succès (étape 250 = 1), le composant programmable 10 cherche à accéder à un code applicatif à exécuter. Pour cela il émet un signal ADR0[24] dans l'état haut 1.

Puisque l'autre entrée de l'élément 47 est dans l'état bas 0, la sortie de l'élément 47 se trouve alors dans l'état haut 1. En conséquence, le composant programmable 10 accède à une zone de la mémoire d'application 30 caractérisée par des adresses dont le bit de poids fort vaut 1. Ainsi, le composant programmable 10 accède effectivement à la seconde zone 34 de la mémoire d'application. A l'étape 260, le composant programmable lit le second code applicatif 35, qui correspond effectivement au code exécutable par le second microprocesseur résultant de la configuration du composant programmable selon le second fichier 35.

A l'étape 270, le composant programmable exécute le second code applicatif.

Celui-ci comporte, entre autre, des instructions relatives à l'émission d'un signal d'inhibition SI du circuit de fiabilisation 42. En conséquence, à l'étape 280, le composant programmable émet sur sa patte WDI0, un signal d'inhibition SI prenant la valeur haute 1.

Le signal d'inhibition SI étant reçu par le circuit de surveillance 42 du circuit de fiabilisation 40 avant la fin de la durée D (étape 290 = 1), le circuit de surveillance réinitialise son horloge (retour à l'étape 110) et n'émet pas de signal de configuration.

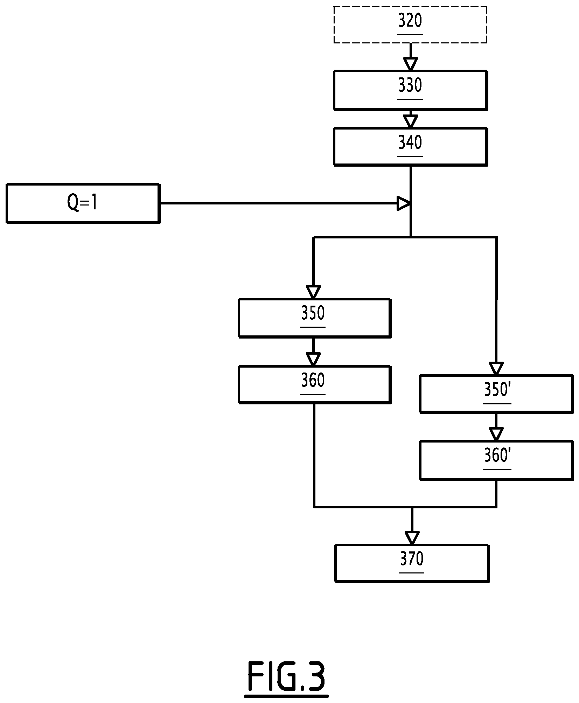

Le procédé peut avantageusement se poursuivre, au cours de l'exécution normale du second code applicatif, par une phase d'écriture d'un nouveau fichier de configuration en remplacement du premier fichier de configuration ayant conduit à un échec de la phase de configuration. Cette phase d'écriture 320 va maintenant être décrite en référence à la figure 3.

Le composant programmable 10 télécharge (étape 330) un nouveau fichier de configuration et un code applicatif associé depuis l'extérieur du système, au travers d'un ensemble de connexions adaptées.

Le composant programmable 10 se charge d'écrire le nouveau fichier dans la mémoire de configuration et le code applicatif dans la mémoire d'application.

Pour écrire dans la première mémoire de configuration, qui est la mémoire qui est opposée à celle contenant le fichier de configuration courante du composant programmable, à l'étape 340, le composant programmable 10 émet un signal sur sa patte WR prenant la valeur haute 1.

La bascule étant dans l'état haut 1, la sortie de l'élément 45 au noeud P1 est dans l'état bas 0, tandis que la sortie de l'élément logique 49 au noeud P2 est dans l'état haut 1.

En conséquence, à l'étape 350, lorsque le composant programmable cherche à accéder à la mémoire de configuration en émettant un signal CS0 dans l'état haut 1, la sortie de l'élément logique 46 est dans l'état haut 1, tandis que la sortie de l'élément logique 48 est dans l'état bas 0.

Dans ces conditions, les pattes d'entrée/sortie du composant programmable sont effectivement connectées à la première mémoire de configuration 22.

Le composant programmable 10 écrit (étape 360) le nouveau fichier de configuration téléchargé, dans la première mémoire de configuration en remplacement du premier fichier de configuration corrompu.

A la fin de l'écriture en mémoire de configuration, les signaux CS0 est placé dans l'état bas 0 (étape 370).

Le composant programmable ne modifie donc pas le second fichier de configuration, qui est stocké dans la seconde mémoire de configuration 24 et qui a permis la configuration actuelle du composant programmable.

A l'étape 350', lorsque le composant programmable cherche à accéder à la mémoire d'application, il émet un signal ADR0[24] dans l'état haut 1. La sortie de l'élément logique 47 est dans l'état bas 0.

Dans ces conditions, les pattes d'entrée/sortie du composant programmable sont effectivement connectées avec la première mémoire d'application 32.

Le composant programmable 10 écrit (étape 360') le nouveau code applicatif téléchargé, dans la première mémoire d'application en remplacement du premier code applicatif.

A la fin de l'écriture en mémoire d'application, le signal ADR0[24] est placé dans l'état bas 0 (étape 370).

Le composant programmable ne modifie donc pas le second code applicatif stocké dans la seconde mémoire d'application et qui est actuellement exécuté par le composant programmable.

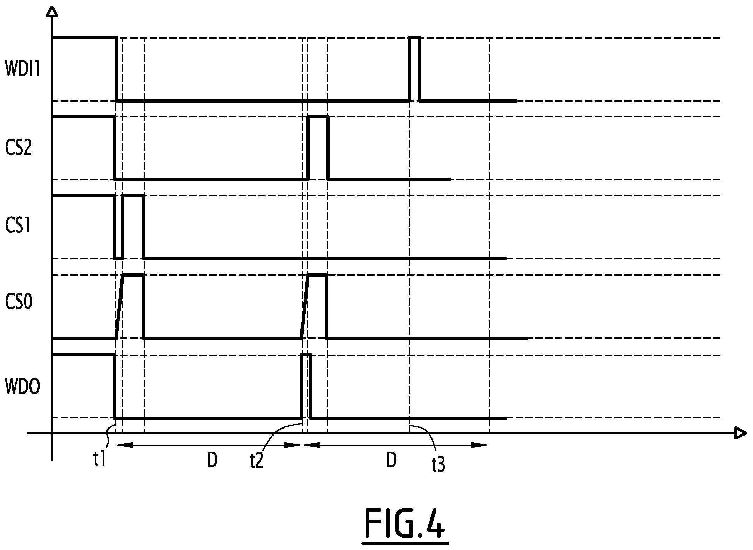

On a représenté à la figure 4, sous forme d'un chronogramme, les signaux sur les pattes WDO du circuit de surveillance, CS0 du composant programmable, CS1 de la première mémoire de configuration 22, CS2 de la seconde mémoire de configuration 24, et WDI1 du circuit de surveillance (correspondant à la patte WD0 du composant programmable).

A l'instant t1, le système est mis sous tension.

Débute alors une première phase de configuration du composant programmable 10.

Dans un premier temps, celui-ci accède à la mémoire de configuration en modifiant le niveau du signal CS0. Ceci a pour conséquence de sélectionner la première mémoire de configuration 22 : le signal CS1 passe dans l'état haut 1, tandis que le signal CS2 reste dans l'état bas 0.

Dès que le premier fichier de configuration a été lu, le signal CS0 repasse dans l'état bas 0, tout comme le signal CS1.

Le composant programmable tente alors de se configurer conformément au premier fichier de configuration 23. Ce premier fichier de configuration étant corrompu, la phase de configuration échoue et ne prend pas fin avant la durée D.

Aucun signal d'inhibition n'étant reçu sur la patte WDI1 du circuit de surveillance 42, celui-ci émet un signal de reconfiguration sur l'entrée CONFIG du composant programmable, à l'instant t2. Cela a également pour effet de modifier l'état de la bascule 44.

Le composant programmable initie alors une seconde phase de configuration.

Le composant programmable cherche à accéder à un fichier de configuration. Pour cela il modifie le niveau du signal CS0 qui passe dans l'état haut 1.

Mais, compte tenu de l'état de la bascule 44, cela a pour effet de sélectionner la seconde mémoire de configuration 24 : le signal CS2 passe à la valeur haute 1, tandis que le signal CS1 reste au niveau bas 0.

Le composant programmable lit le second fichier de configuration 25.

A l'issue de cet accès à la mémoire de configuration, le composant programmable replace le signal CS0 dans l'état bas 0. C'est la raison pour laquelle, le signal CS2 revient également dans son niveau bas 0 à cet instant.

Le composant programmable utilise le second fichier pour se configurer. La phase de configuration s'achève correctement. Le composant programmable charge alors le second code applicatif 35 et l'exécute. Un signal d'inhibition SI est émis depuis le composant programmable 10 vers le circuit de surveillance 42, à l'instant t3. L'intervalle de temps entre les instants t2 et t3 étant inférieur à la durée D, l'horloge du circuit de surveillance 42 est remise à zéro avant qu'un signal de reconfiguration ne soit émis par le circuit de surveillance sur sa sortie WDO.

On notera que, sur le schéma de la figure 1, la patte CONFIG du composant programmable et la patte WDO du circuit de surveillance sont reliées à travers une diode 43. Un signal de reconfiguration généré par le circuit de surveillance peut ainsi être appliqué sur la patte CONFIG tout en modifiant l'état de la bascule 44, tandis qu'un signal de reconfiguration appliqué sur la patte CONFIG depuis l'extérieur du système, par exemple au moyen d'un lien JTAG, ne peut pas être appliqué sur l'entrée de la bascule. La diode protège la bascule et évite des changements intempestifs de l'état de la bascule lors d'une configuration commandée depuis l'extérieur, par exemple lors du test d'un fichier de configuration et/ou d'un code applicatif.

Dans le mode de réalisation de la figure 1, les premier et second espaces mémoire de configuration prennent la forme de deux mémoires indépendantes l'une de l'autre, tandis que les premier et second espaces mémoire d'application prennent la forme d'une unique mémoire unique divisée en deux zones adressables séparément. L'homme du métier comprendra que, dans d'autres modes de réalisation, les premier et second espaces mémoire de configuration prennent la forme d'une unique mémoire subdivisée en deux zones, et/ou que les premier et second espaces mémoire d'application prennent la forme de deux mémoires indépendantes.

Le composant programmable doit émettre périodiquement un signal d'inhibition du circuit de surveillance. Il s'agit d'une fonction classique pour les microprocesseurs usuels, « non reconfigurables ». En effet, un tel microprocesseur est usuellement associé à un circuit de surveillance qui, s'il ne reçoit pas de signal d'inhibition de la part du microprocesseur (par exemple bloqué dans l'exécution d'une boucle d'instructions sans fin), émet un signal de réinitialisation (« reset ») du microprocesseur.

Dans une autre variante, indépendante des précédentes, le système comporte N fichiers de configuration, stockés dans N espaces mémoire de configuration, et N codes applicatifs, stockés dans N espaces mémoire d'application. Chaque code est associé à un unique fichier de configuration. Le circuit de fiabilisation est par conséquent à N niveaux.

En variante, le composant programmable intègre tout ou partie du circuit de fiabilisation de sa configuration. Un tel composant programmable avancé correspond avantageusement à la réunion au sein d'un même dispositif des éléments 10, 42, 43, 44, 45, 46, 47, 48, 49 de la figure 1. L'homme du métier constatera que les éléments précédemment mentionnés sont du même type que les éléments constitutifs des composants programmables : circuits de surveillance, bascules et éléments logiques... Il est aisé de les prévoir et de les intégrer lors de la fabrication du composant programmable amélioré. De plus, ces éléments sont simples et fiables.

Dans encore une autre variante, dans le but d'augmenter la sûreté du fonctionnement du système, le premier espace mémoire de configuration est une mémoire non reconfigurable comportant un fichier de configuration usine et dans laquelle il est impossible d'écrire à nouveau ; tandis que le second espace mémoire de configuration est une mémoire reconfigurable comportant un fichier de configuration de mise à jour de la configuration et dans laquelle il est possible d'écrire un nouveau fichier de configuration en écrasant le précédent. L'utilisation du composant programmable est alors bridée au sens où il n'est alors plus possible de modifier, au cours de l'utilisation du composant programmable, que le second fichier de configuration correspondant à une mise à jour de la configuration. On est ainsi sûr qu'au cas où ce second fichier de configuration est corrompu, le composant programmable pourra être configuré à partir du fichier de configuration usine. Le circuit de fiabilisation décrit en détail précédemment doit être adapté pour ne pas proposer l'accès en écriture au premier espace mémoire de configuration. Ce qui vient d'être indiqué pour les espaces mémoire de configuration est applicable aux espaces mémoire d'application.

## Revendications

1. Dispositif programmable, **caractérisé en ce qu'**il comporte :
- un composant programmable (10) capable de gérer sa propre configuration, à partir de la donnée d'un fichier de configuration, ayant une sortie (WDI0) apte à émettre un signal d'inhibition lors d'une configuration réussie du composant programmable et une entrée (CONFIG) apte à recevoir un signal de reconfiguration ;
- un circuit (40) de fiabilisation automatique de la configuration du composant programmable, comportant :
- un moyen de sélection à au moins deux états (44, 45, 46, 47, 48, 49), dans un premier état, le moyen de sélection est propre à connecter le composant programmable à un premier espace mémoire de configuration (22) comportant un premier fichier de configuration (23), au moins quand le composant programmable cherche à accéder en lecture à un fichier de configuration et, dans un second état, le moyen de sélection est propre à connecter le composant programmable à un second espace mémoire de configuration (24) comportant un second fichier de configuration (25), au moins quand le composant programmable cherche à accéder en lecture à un fichier de configuration ; et,
- un moyen de surveillance (42) ayant une entrée (WDI1) apte à recevoir le signal d'inhibition émis par le composant programmable et une sortie (WD0) apte à émettre, lorsque aucun signal d'inhibition n'a été reçu pendant une durée prédéterminée, un signal de reconfiguration à destination du composant programmable pour en commander la reconfiguration et du moyen de sélection pour en modifier l'état.

2. Dispositif selon la revendication 1, **caractérisé en ce que** ledit composant programmable (10), une fois configuré en tant que microprocesseur, est propre à exécuter un code applicatif associé au fichier de configuration utilisé, et **en ce que** ledit moyen de sélection (44, 45, 46, 47, 48, 49) est propre à :
- dans ledit premier état, connecter le composant programmable à un premier espace mémoire d'application (32) comportant un premier code d'application (33), au moins quand le composant programmable cherche à accéder en lecture à un code d'application ; et,
- dans ledit second état, connecter le composant programmable à un second espace mémoire d'application (34) comportant un second code d'application (35), au moins quand le composant programmable cherche à accéder en lecture à un code d'application,

3. Dispositif selon la revendication 1 ou la revendication 2, **caractérisé en ce que** le moyen de sélection comporte :
- une bascule (44) à au moins deux états comportant une entrée (CLK) de commande d'une modification de l'état de la bascule et une sortie (Q) d'indication de l'état courrant de la bascule, ladite entrée étant connectée à ladite sortie (WD0) du moyen de surveillance apte à émettre un signal de reconfiguration ; et,
- une pluralité de composants logiques (45, 46, 47, 48, 49) propre à connecter le composant programmable au premier espace mémoire de configuration (22) ou au second espace mémoire de configuration (24), en fonction de l'état courrant de la bascule.

4. Dispositif selon la revendication 2 et la revendication 3 en combinaison, **caractérisé en ce que** ladite pluralité de composants logiques (45, 46, 47, 48, 49) est propre à connecter le composant programmable (10) au premier espace mémoire d'application (32) ou au second espace mémoire d'application (34), en fonction de l'état courant de la bascule.

5. Dispositif selon la revendication 3 ou la revendication 4, **caractérisé en ce que** le composant programmable (10) comporte une patte de sortie (CS0) sur laquelle il est propre à émettre un signal d'accès indiquant qu'il cherche à accéder à un fichier de configuration, et **en ce que** ladite pluralité de composants logiques (45, 46, 47, 48, 49) est propre à connecter le composant programmable au premier espace mémoire de configuration ou au second espace mémoire de configuration, en fonction de l'état courrant dudit signal d'accès.

6. Dispositif selon la revendication 4 ou la revendication 5, **caractérisé en ce que** le composant programmable (10) comporte une patte de sortie (ADR0[24]) sur laquelle il est propre à émettre un signal d'accès indiquant qu'il cherche à accéder à un code applicatif, et **en ce que** ladite pluralité de composants logiques (45, 46, 47, 48, 49) est propre à connecter le composant programmable au premier espace mémoire d'application ou au second espace mémoire d'application, en fonction de l'état courrant dudit signal d'accès.

7. Dispositif selon l'une quelconque des revendications 1 à 6, **caractérisé en ce que** ledit premier espace mémoire de configuration est une mémoire non reconfigurable et comporte un fichier de configuration usine, **en ce que** ledit second espace mémoire de configuration est une mémoire reconfigurable et comporte un fichier de configuration de mise à jour, et **en ce que**, le composant programmable étant configuré à partir du fichier de configuration usine ou du fichier de configuration de mise à jour, ledit moyen de sélection (44, 45, 46, 47, 48, 49) est propre à connecter le composant programmable au second espace mémoire de configuration (24, 22), au moins quand le composant programmable cherche à accéder en écriture à une mémoire de configuration, pour y écrire un nouveau fichier de configuration de mise à jour.

8. Dispositif selon l'une quelconque des revendications 3 à 7, **caractérisé en ce que** le composant programmable (10) comporte une sortie (WR) sur laquelle il est propre à émettre un signal de sélection en écriture d'un espace mémoire de configuration dans lequel écrire un nouveau fichier de configuration, et **en ce que** ladite pluralité de composants logiques (44, 45, 46, 47, 48, 49) est propre à connecter le composant programmable au premier espace mémoire de configuration ou au second espace mémoire de configuration, en fonction dudit signal de sélection en écriture.

9. Dispositif selon l'une quelconque des revendications 1 à 8, **caractérisé en ce que** ledit composant programmable (10) comporte ledit circuit de fiabilisation de la configuration (40).

10. Dispositif selon l'une quelconque des revendications 1 à 9, **caractérisé en ce que** ledit composant programmable (10) est du type FPGA.

11. Système programmable (1), **caractérisé en ce qu'**il comporte un dispositif conforme à l'une quelconque des revendications 1 à 10, ainsi que des premier et second espace de mémoire de configuration comportant respectivement des premier et second fichiers de configuration, et des premier et second espaces mémoire d'application comportant respectivement des premier et second codes applicatifs, le premier code étant exécutable par le composant programmable dudit dispositif configuré à partir dudit premier fichier de configuration et le second code étant exécutable par le composant programmable dudit dispositif configuré à partir dudit second fichier de configuration, le circuit de fiabilisation de la configuration du composant programmable servant d'interface de connexion entre le composant programmable et lesdits espaces mémoire.

12. Système selon la revendication 11, **caractérisé en ce qu'**il est fermé.

13. Procédé de configuration d'un dispositif programmable selon la revendication 1 comportant des étapes mettant en oeuvre le composant programmable capable de gérer sa propre configuration et le circuit de fiabilisation automatique de la configuration du composant programmable compris dans ledit dispositif programmable, ledit procédé comprenant entre autre les étapes consistant à :
- connecter le composant programmable à un premier espace mémoire de configuration (22) comportant un premier fichier de configuration (23), au moins quand le composant programmable cherche à accéder en lecture à un fichier de configuration ; et, en cas d'échec de la configuration du composant programmable à partir du premier fichier de configuration,
- commander une reconfiguration du composant programmable et connecter le composant programmable à un second espace mémoire de configuration (24) comportant un second fichier de configuration (25) au moins quand le composant programmable cherche à accéder en lecture à un fichier de configuration.

14. Procédé selon la revendication 13, **caractérisé en ce que**, ledit composant programmable (10) une fois configuré en tant que microprocesseur étant propre à exécuter un code applicatif associé au fichier de configuration utilisé, le procédé comporte les étapes consistant à :
- connecter le composant programmable à un premier espace mémoire d'application (32) comportant un premier code applicatif (33), au moins quand le composant programmable cherche à accéder en lecture à un code applicatif ; et, en cas d'échec de la configuration du composant programmable à partir du premier fichier de configuration,
- connecter le composant programmable à un second espace mémoire d'application (34) comportant un second code applicatif (35), au moins quand le composant programmable cherche à accéder en lecture à un code applicatif.

15. Procédé selon la revendication 13, **caractérisé en ce qu'**une fois le composant programmable configuré en utilisant le fichier de configuration contenu dans l'un parmi les premier et second espaces mémoire de configuration (22, 24) et exécutant le code applicatif associé, le procédé comporte les étapes de :
- téléchargement par le composant programmable d'un nouveau fichier de configuration ;
- connecter le composant programmable à l'autre espace mémoire de configuration (22, 24) quand le composant programmable cherche à accéder en écriture à l'espace mémoire de configuration.

## Patentansprüche

1. Programmierbare Vorrichtung, **dadurch gekennzeichnet, dass** sie umfasst:
- eine programmierbare Komponente (10), die in der Lage ist, ihre eigene Konfiguration aus den Daten einer Konfigurationsdatei zu verwalten, wobei die Komponente einen Ausgang (WDI0), der geeignet ist, ein Sperrsignal bei einer erfolgreichen Konfiguration der programmierbaren Komponente abzugeben, und einen Eingang (CONFIG) aufweist, der geeignet ist, ein Rekonfigurationssignal zu empfangen;
- einen Schaltkreis (40) zur automatischen Optimierung der Konfiguration der programmierbaren Komponente, umfassend:
- ein Mittel zur Auswahl von mindestens zwei Zuständen (44, 45, 46, 47, 48, 49), wobei in einem ersten Zustand das Auswahlmittel ausgebildet ist, die programmierbare Komponente mit einem ersten, eine erste Konfigurationsdatei (23) aufweisenden Konfigurationsspeicherraum (22) zu verbinden, zumindest, wenn die programmierbare Komponente versucht, eine Konfigurationsdatei zu lesen, und das Auswahlmittel in einem zweiten Zustand ausgebildet ist, die programmierbare Komponente mit einem zweiten, eine zweite Konfigurationsdatei (25) aufweisenden Konfigurationsspeicherraum (24) zu verbinden, zumindest wenn die programmierbare Komponente versucht, eine Konfigurationsdatei zu lesen; und
- ein Überwachungsmittel (42), das einen Eingang (WDI1), der geeignet ist, das von der programmierbaren Komponente gelieferte Sperrsignal zu empfangen, und einen Ausgang (WD0) aufweist, der geeignet ist, wenn überhaupt kein Sperrsignal während einer vorbestimmten Dauer empfangen wurde, ein Rekonfigurationssignal an die programmierbare Komponente zur Steuerung ihrer Rekonfiguration und an das Auswahlmittel zum Modifizieren seines Zustandes zu senden.

2. Vorrichtung nach Anspruch 1, **dadurch gekennzeichnet, dass** die programmierbare Komponente (10), sobald sie als Mikroprozessor konfiguriert ist, geeignet ist, einen Anwendungscode, der der verwendeten Konfigurationsdatei zugeordnet ist, auszuführen, und dass das Auswahlmittel (44, 45, 46, 47, 48, 49) ausgebildet ist:
- in dem ersten Zustand die programmierbare Komponente mit einem ersten Anwendungsspeicherraum (32), der einen ersten Anwendungscode (33) aufweist, zu verbinden, zumindest wenn die programmierbare Komponente versucht, einen Anwendungscode zu lesen; und
- in dem zweiten Zustand die programmierbare Komponente mit einem zweiten Anwendungsspeicherraum (34), der einen zweiten Anwendungscode (35) aufweist, zu verbinden, zumindest wenn die programmierbare Komponente versucht, einen Anwendungscode zu lesen.

3. Vorrichtung nach Anspruch 1 oder Anspruch 2, **dadurch gekennzeichnet, dass** das Auswahlmittel umfasst:
- eine Kippstufe (44) mit mindestens zwei Zuständen, die einen Eingang (CLK) zum Steuern einer Modifikation des Zustands der Kippstufe und einen Ausgang (Q) zur Anzeige des aktuellen Zustands der Kippstufe aufweist, wobei der Eingang mit dem Ausgang (WD0) des Überwachungsmittels verbunden ist, das in der Lage ist, ein Rekonfigurationssignal zu senden; und
- eine Mehrzahl von logischen Komponenten (45, 46, 47, 48, 49), die ausgebildet sind, die programmierbare Komponente mit dem ersten Konfigurationsspeicherraum (22) oder dem zweiten Konfigurationsspeicherraum (24) abhängig von dem aktuellen Zustand der Kippstufe zu verbinden.

4. Vorrichtung nach Anspruch 2 und Anspruch 3 in Kombination, **dadurch gekennzeichnet, dass** die Mehrzahl von logischen Komponenten (45, 46, 47, 48, 49) ausgebildet ist, die programmierbare Komponente (10) mit dem ersten Anwendungsspeicherraum (32) oder dem zweiten Anwendungsspeicherraum (34) abhängig von dem aktuellen Zustand der Kippstufe zu verbinden.

5. Vorrichtung nach Anspruch 3 oder Anspruch 4, **dadurch gekennzeichnet, dass** die programmierbare Komponente (10) eine Ausgangsleitung (CS0) aufweist, über die sie ein Zugangssignal zu senden in der Lage ist, das angibt, dass sie auf eine Konfigurationsdatei zugreifen will, und dass die Mehrzahl von logischen Komponenten (45, 46, 47, 48, 49) ausgebildet ist, die programmierbare Komponente mit dem ersten Konfigurationsspeicherraum oder dem zweiten Konfigurationsspeicherraum abhängig von dem aktuellen Zustand des Zugangssignals zu verbinden.

6. Vorrichtung nach Anspruch 4 oder Anspruch 5, **dadurch gekennzeichnet, dass** die programmierbare Komponente (10) eine Ausgangsleitung (ADR0[24]) aufweist, über die sie, ein Zugangssignal zu senden in der Lage ist, das angibt, dass sie auf einen Anwendungscode zugreifen will, und dass die Mehrzahl von logischen Komponenten (45, 46, 47, 48, 49) ausgebildet ist, die programmierbare Komponente mit dem ersten Anwendungsspeicherraum oder dem zweiten Anwendungsspeicherraum abhängig von dem aktuellen Zustand des Zugangssignals zu verbinden.

7. Vorrichtung nach einem beliebigen der Ansprüche 1 bis 6, **dadurch gekennzeichnet, dass** der erste Konfigurationsspeicherraum ein nichtkonfigurierbarer Speicher ist und eine werkseitige Konfigurationsdatei aufweist, dass der zweite Konfigurationsspeicherraum ein rekonfigurierbarer Speicher ist und eine aktualisierte Konfigurationsdatei aufweist, und dass, wenn die programmierbare Komponente über die werkseitige Konfigurationsdatei oder die aktualisierte Konfigurationsdatei konfiguriert ist, das Auswahlmittel (44, 45, 46, 47, 48, 49) ausgebildet ist, die programmierbare Komponente mit dem zweiten Konfigurationsspeicherraum (24, 22) zu verbinden, zumindest wenn die programmierbare Komponente versucht, auf einen Konfigurationsspeicher zum Schreiben zuzugreifen, um eine neue aktualisierte Konfigurationsdatei einzuschreiben.

8. Vorrichtung nach einem beliebigen der Ansprüche 3 bis 7, **dadurch gekennzeichnet, dass** die programmierbare Komponente (10) einen Ausgang (WR) aufweist, über den sie ein Auswahlsignal zum Schreiben in einen Konfigurationsspeicherraum, in den eine neue Konfigurationsdatei zu schreiben ist, zu senden in der Lage ist und dass die Mehrzahl von logischen Komponenten (44, 45, 46, 47, 48, 49) geeignet ist, die programmierbare Komponente mit dem ersten Konfigurationsspeicherraum oder dem zweiten Konfigurationsspeicherraum abhängig von dem Schreibauswahlsignal zu verbinden.

9. Vorrichtung nach einem beliebigen der Ansprüche 1 bis 8, **dadurch gekennzeichnet, dass** die programmierbare Komponente (10) den Schaltkreis (40) zur Optimierung der Konfiguration aufweist.

10. Vorrichtung nach einem beliebigen der Ansprüche 1 bis 9, **dadurch gekennzeichnet, dass** die programmierbare Komponente (10) als FPGA ausgebildet ist.

11. Programmierbares System (1), **dadurch gekennzeichnet, dass** es eine Vorrichtung nach einem beliebigen der Ansprüche 1 bis 10 sowie einen ersten und zweiten Konfigurationsspeicherraum, die jeweils eine erste und zweite Konfigurationsdatei aufweisen, und einen ersten und zweiten Anwendungsspeicherraum, die jeweils erste und zweite Anwendungscodes aufweisen, umfasst, wobei der erste Code von der programmierbaren Komponente der Vorrichtung ausführbar ist, die anhand der ersten Konfigurationsdatei konfiguriert ist, und der zweite Code von der programmierbaren Komponente der Vorrichtung ausführbar ist, die anhand der zweiten Konfigurationsdatei konfiguriert ist, wobei der Schaltkreis zur Optimierung der Konfiguration der programmierbaren Komponente als Verbindungsschnittstelle zwischen der programmierbaren Komponente und den Speicherräumen dient.

12. System nach Anspruch 11, **dadurch gekennzeichnet, dass** es geschlossen ist.

13. Verfahren zur Konfiguration einer programmierbaren Vorrichtung nach Anspruch 1, das Schritte umfasst, die die programmierbare Komponente, die ihre eigene Konfiguration zu verwalten in der Lage ist, und den Schaltkreis der automatischen Optimierung der Konfiguration der programmierbaren Komponente, die in der programmierbaren Vorrichtung enthalten ist, realisieren, wobei das Verfahren unter anderem die Schritte umfasst, die darin bestehen:
- die programmierbare Komponente mit einem ersten, eine erste Konfigurationsdatei (23) aufweisenden Konfigurationsspeicherraum (22) zu verbinden, zumindest wenn die programmierbare Komponente versucht, eine Konfigurationsdatei zu lesen, und im Falle des Scheiterns der Konfiguration der programmierbaren Komponente über die erste Konfigurationsdatei ,
- eine Rekonfiguration der programmierbaren Komponente zu steuern und die programmierbare Komponente mit einem zweiten, eine zweite Konfigurationsdatei (25) aufweisenden Konfigurationsspeicherraum (24) zu verbinden, zumindest wenn die programmierbare Komponente versucht, eine Konfigurationsdatei zu lesen.

14. Verfahren nach Anspruch 13, **dadurch gekennzeichnet, dass** die programmierbare Komponente (10), sobald sie als Mikroprozessor konfiguriert ist, geeignet ist, einen der verwendeten Konfigurationsdatei zugeordneten Anwendungscode durchzuführen, wobei das Verfahren die Schritte aufweist, die darin bestehen:
- die programmierbare Komponente mit einem ersten Anwendungsspeicherraum (32), der einen ersten Anwendungscode (339 aufweist, zu verbinden, zumindest wenn die programmierbare Komponente versucht, einen Anwendungscode zu lesen; und im Falle des Scheiterns der Konfiguration der programmierbaren Komponente über die erste Konfigurationsdatei
- die programmierbare Komponente mit einem zweiten Anwendungsspeicherraum (34), die einen zweiten Anwendungscode (35) aufweist, zu verbinden, zumindest wenn die programmierbare Komponente versucht, einen Anwendungscode zu lesen.

15. Verfahren nach Anspruch 13, **dadurch gekennzeichnet, dass**, sobald die programmierbare Komponente unter Verwendung der Konfigurationsdatei, die im ersten oder dem zweiten Konfigurationsspeicherraum (22, 24) enthalten ist, konfiguriert ist und der zugeordnete Anwendungscode ausgeführt wird, das Verfahren die Schritte umfasst:
- Herunterladen einer neuen Konfigurationsdatei durch die programmierbare Komponente;
- Verbinden der programmierbaren Komponente mit dem anderen Konfigurationsspeicherraum (22, 24), wenn die programmierbare Komponente versucht, in den Konfigurationsspeicherraum zu schreiben.

## Claims

1. A programmable device, **characterized in that** it includes:
- a programmable component (10) capable of managing its own configuration, from a configuration file, having an output (WDI0) able to send an inhibiting signal upon successful configuration of the programmable component and an input (CONFIG) able to receive a reconfiguration signal;
- a circuit (40) for the automatic burn-in of the configuration of the programmable component, having:
- means for selecting having at least two states (44, 45, 46, 47, 48, 49), in a first state, the selection means can connect the programmable component to a first configuration memory space (22) having a first configuration file (23), at least when the programmable component seeks to access a configuration file in read mode and, in a second state, the selection means can connect the programmable component to a second configuration memory space (24) having a second configuration file (25), at least when the programmable component seeks to access a configuration file in read mode; and
- watchdog means (42) having an input (WDI1) able to receive the inhibition signal sent by the programmable component and an output (WD0) able to send, when no inhibition signal has been received for a predetermined period of time, a configuration signal intended for the programmable component to command the reconfiguration thereof and for the selection means to modify the state thereof.

2. The device according to claim 1, **characterized in that** said programmable component (10), once configured as a microprocessor, can execute an application code associated with the configuration file used, and **in that** the selection means (44, 45, 46, 47, 48, 49) can:
- in said first state, connect the programmable component to a first application memory space (32) having a first application code (33), at least when the programmable component seeks to access an application in ready-only mode; and
- in said second state, connect the programmable component to a second application memory space (34) having a second application code (35), at least when the programmable component seeks to access an application in read-only mode.

3. The device according to claim 1 or claim 2, **characterized in that** the selection means comprise:
- a latch (44) with at least two states including an input (CLK) for controlling a change in the state of the latch and an output (Q) indicating the current state of the latch, said input being connected to said output (WD0) of the watchdog means able to send a reconfiguration signal; and
- a plurality of logic components (45, 46, 47, 48, 49) that can connect the programmable component to the first configuration memory space (22) or to the second configuration memory space (24), depending on the current state of the latch.

4. The device according to claim 2 and claim 3 combined, **characterized in that** the plurality of logic components (45, 46, 47, 48, 49) can connect the programmable component (10) to the first application memory space (32) or the second application memory space (34), depending on the current state of the latch.

5. The device according to claim 3 or claim 4, **characterized in that** the programmable component (10) has an output pin (CS0) on which it can send an access signal indicating that it is trying to access a configuration file, and the plurality of logic components (45, 46, 47, 48, 49) can connect the programmable component to the first configuration memory space or the second configuration memory space, depending on the current state of said access signal.

6. The device according to claim 4 or claim 5, **characterized in that** the programmable component (10) has an output pin (ADR0[24]) on which it can send an access signal indicating that it is seeking to access an application code, and **in that** the plurality of logic components (45, 46, 47, 48, 49) can connect the programmable component to the first application memory space or the second application memory space, depending on the current state of said access signal.

7. The device according to any one of claims 1 to 6, **characterized in that** said first configuration memory space is a non-reconfigurable memory and has a factory configuration file, **in that** said second configuration memory space is a reconfigurable memory and has an update configuration file, and **in that**, the programmable component being configured from the factory configuration file or the update configuration file, said selection means (44, 45, 46, 47, 48, 49) can connect the programmable component to the second configuration memory space (24, 22), at least when the programmable component seeks to access a configuration memory in write mode to write a new update configuration file there.

8. The device according to any one of claims 3 to 7, **characterized in that** the programmable component (10) has an output (WR) on which it can send a write-mode selection signal for a configuration memory space in which to write a new configuration file, and **in that** the plurality of logic components (44, 45, 46, 47, 48, 49) can connect the programmable component to the first configuration memory space or the second configuration memory space, depending on the write-mode selection signal.

9. The device according to any one of claims 1 to 8, **characterized in that** said programmable component (10) includes the burn-in circuit for the configuration (40).

10. The device according to any one of claims 1 to 9, **characterized in that** the programmable component (10) is of the FPGA type.

11. A programmable system (1), **characterized in that** it has a device according to any one of claims 1 to 10, as well as first and second configuration memory spaces respectively including first and second configuration files, and first and second application memory spaces respectively including first and second application codes, the first code being executable by the programmable component of said device configured from said first configuration file and the second code being executable by the programmable component of said device configured from said second configuration file, the burn-in circuit of the configuration of the programmable component serving as a connection interface between the programmable component and said memory spaces.

12. The system according to claim 11, **characterized in that** it is closed.

13. A method for the configuration of a programmable device according to claim 1 comprising steps using the programmable component capable of managing its own configuration and the circuit for the automatic burn-in of the configuration of the programmable component of the programmable device, the method comprising the steps consisting in:
- connecting the programmable component to a first configuration memory space (22) including a first configuration file (23), at least when the programmable component seeks to access a configuration file in read mode; and, in the event the configuration of the programmable component fails, from the first configuration file;
- commanding a reconfiguration of the programmable component and connecting the programmable component to a second configuration memory space (24) having a second configuration file (25) at least when the programmable component seeks to access a configuration file in read mode.

14. The method according to claim 13, **characterized in that** said programmable component (10), once configured as a microprocessor, being able to execute an application code associated with the configuration file used, the method includes the following steps:
- connecting the programmable component to a first application memory space (32) including a first application code (33), at least when the programmable component is seeking to access an application code in read mode; and, in the event the configuration of the programmable component from the first configuration file fails,
- connecting the programmable component to a second application memory space (34) having a second application code (35), at least when the programmable component is seeking to access an application code in read mode.

15. The method according to claim 13, **characterized in that** once the programmable component is configured using the configuration file contained in one of the first and second configuration memory spaces (22, 24) and executing the associated application code, the method includes the following steps:
- downloading by the programmable component of a new configuration file;
- connecting the programmable component to the other configuration memory space (22, 24) when the programmable component is seeking to access the configuration memory space in write mode.
